# EUROPEAN PATENT APPLICATION

(11) **EP 4 258 339 A1**
(43) Date of publication of application: **11.10.2023**
(21) Application number: 23164683.7
(22) Date of filing: 28.03.2023
(51) Int. Cl.: H01L 23/29, H01L 23/053, H01L 25/07, H01L 23/24, H01L 23/31

(54) **ANTI-CORROSION PARTICLES IN SEMICONDUCTOR DEVICE**

(30) Priority: 07.04.2022 US 202217715108
(71) Applicant: Infineon Technologies AG, 85579 Neubiberg (DE)
(72) Inventor: UHLIG, Johannes, 59494 Soest (DE); WILKE, Ulrich, 59494 Soest (DE)
(74) Representative: Westphal, Mussgnug & Partner, Patentanwälte mbB

(57) **Abstract**

A semiconductor module includes a power electronics carrier including a structured metallization layer (104) disposed on an electrically insulating substrate (106), a power semiconductor die (108) mounted on the power electronics carrier, a housing (118) that surrounds an interior volume over the power electronics carrier, a volume of electrically insulating polymer material (126) disposed within the interior volume, and a concentration of sacrificial particles (128) dispersed within the volume of electrically insulating polymer, wherein the sacrificial particles are a metal salt, semi-metal salt, metal oxide, or semi-metal oxide with a cation.

## Description

### BACKGROUND

Many different applications such as automotive and industrial applications utilize power semiconductor devices that are rated to accommodate voltages on the order of 600 V(volts), 1200 V or more. These power semiconductor devices may be arranged as a power conversion circuit such as a single and multi-phase half-wave rectifier, single and multi-phase full-wave rectifier, voltage regulator, inverter, etc. Some power applications utilize power modules comprising power semiconductor dies and associated logic and passives in a single housing. Some applications utilize discrete semiconductor packages that include power semiconductor dies encapsulated within a molded package body.

Power devices are susceptible to corrosion in certain environments. For example, some application environments include sulfur containing gases, e.g., Hydrogen Sulfide (H₂S), gaseous sulfur (S8), methanethiol (CH₃SH), and dimethyl sulfide ((CH₃)₂S), etc., that can penetrate most dense types of material and can cause significant unwanted and damaging corrosion to metal surfaces. Current solutions for protecting electronic components of semiconductor devices from this type of corrosion are expensive to implement and/or ineffective in all conditions.

### SUMMARY

A semiconductor module is disclosed. According to an embodiment, the semiconductor module comprises a power electronics carrier comprising a structured metallization layer disposed on an electrically insulating substrate, a power semiconductor die mounted on the power electronics carrier, a housing that surrounds an interior volume over the power electronics carrier, a volume of electrically insulating polymer material disposed within the interior volume, and a concentration of sacrificial particles dispersed within the volume of electrically insulating polymer, wherein the sacrificial particles are a metal salt, semi-metal salt, metal oxide, or semi-metal oxide with a cation.

A semiconductor device is disclosed. According to an embodiment, the semiconductor device comprises a semiconductor die, an encapsulant body of electrically insulating material that encapsulates the semiconductor die, and a concentration of sacrificial particles dispersed within an electrically insulating region of the semiconductor device, wherein the sacrificial particles comprise a metal salt, semi-metal salt, metal oxide, or semi-metal oxide with a cation.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1 illustrates a semiconductor module with a concentration of sacrificial particles dispersed within a volume of polymer material, according to an embodiment.
Figure 2 illustrates a semiconductor module with a concentration of sacrificial particles dispersed within a volume of polymer material, according to another embodiment.
Figure 3, which includes Figs. 3A and 3B, illustrates a semiconductor package with a concentration of sacrificial particles dispersed within a volume of polymer material, according to an embodiment. Fig. 3A illustrates an exterior view of the semiconductor package; and Fig. 3B illustrates an interior view of the semiconductor package.

### DETAILED DESCRIPTION

Embodiments of a semiconductor device with a concentration of sacrificial particles dispersed within a volume of electrically insulating polymer are described herein. The volume of electrically insulating polymer may be any dielectric that encapsulates or contacts a metal surface that is susceptible to corrosion, e.g., a potting compound of a power module, an adhesive layer of a power module, a coating layer, a mold compound, etc. The sacrificial particles are configured react with corrosive gases that may diffuse into the volume of electrically insulating polymer and thereby deprive the protected metal surface of a corresponding corrosive reaction. According to embodiments described herein, the sacrificial particles are a metal salt, semi-metal salt, metal oxide, or semi-metal oxide with a cation. Sacrificial particles of this type offer numerous advantages. For example, these particles can form a stable sulfide with a sulfur containing gas, e.g., Hydrogen Sulfide (H₂S), in low pressure and/or low moisture conditions. Additionally, the metal salt or metal oxide can be electrically non-conductive, thereby maintaining the dielectric strength of the electrically insulating polymer to which they are dispersed in. Additionally, the granular size of the sacrificial particles allows them to be incorporated into a polymer with a low viscosity, which aids in the formation of an effective encapsulant.

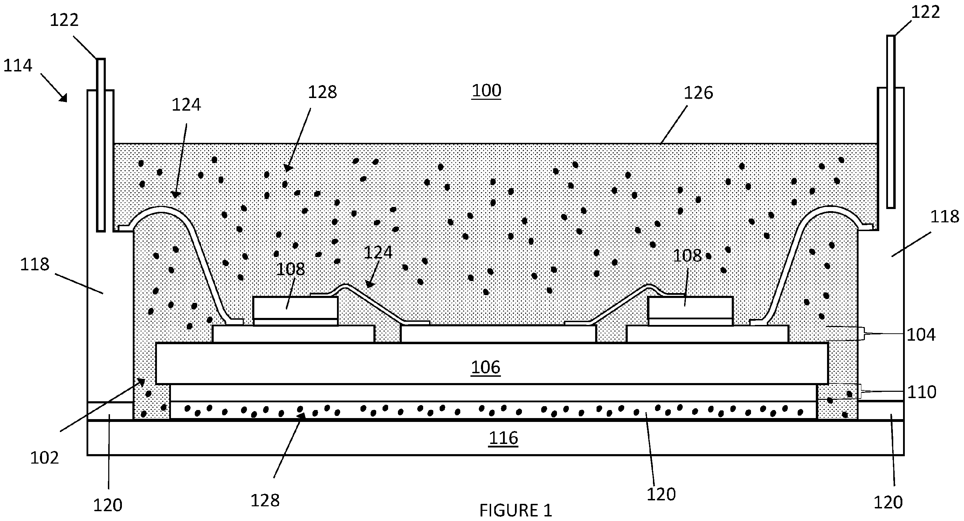

Referring to Figure 1, a semiconductor module 100 is depicted, according to an embodiment. The semiconductor module 100 comprises a circuit carrier 102. The circuit carrier 102 is a circuit carrier that is configured to accommodate the mounting of multiple power semiconductor devices thereon and to efficiently extract heat away from these power semiconductor devices during operation. The circuit carrier 102 comprises a structured metallization layer 104 disposed on an electrically insulating substrate 106. The structured metallization layer 104 comprises a plurality of pads that are disposed on the electrically insulating substrate 106 and are electrically isolated from one another. The pads are dimensioned to accommodate the mounting of semiconductor dies 108 or passive elements thereon. Additionally, the pads can form part of an electrical interconnect structure that connects two or more devices together. The circuit carrier 102 additionally comprises a second metallization layer 110 disposed on a rear side of the electronics circuit carrier 102. The second metallization layer 110 may be a continuous layer that can thermally couple the circuit carrier 102 to a cooling apparatus, such as a heat sink. The first structured metallization layer 104 and the second metallization layer 110 may comprise or be plated with any or more of Cu, Ni, Ag, Au, Pd, Pt, NiV, NiP, NiNiP, NiP/Pd, Ni/Au, NiP/Pd/Au, or NiP/Pd/AuAg.

According to an embodiment, the circuit carrier 102 is a power electronics carrier, such as a Direct Copper Bonding (DCB) substrate, a Direct Aluminum Bonding (DAB) substrate, or an Active Metal Brazing (AMB) substrate, or an Insulated Metal Substrate (IMS). A DCB substrate, DAB substrate, or AMB substrate may comprise a ceramic material such as Al₂O₃ (Alumina) AIN (Aluminium Nitride), etc. as the electrically insulating substrate 106. An IMS substrate may comprise filled materials such as epoxy resin or polyimide as the electrically insulating substrate 106. The circuit carrier 102 may also be a printed circuit board (PCB). In that case, the electrically insulating substrate 106 may comprise a resin material such as FR-4.

The semiconductor module 100 comprises semiconductor dies 108 mounted on the circuit carrier 102. The semiconductor dies 108 may be mounted and (optionally) electrically connected to the structured pads of the structured metallization layer 104 by a conductive adhesive, e.g., solder, sinter, conductive glue, etc. According to an embodiment, one or more of the semiconductor dies 108 is configured as a power semiconductor die. A power semiconductor die refers to a single device that is rated to accommodate voltages of at least 100 V (volts), and more typically voltages of 600 V, 1200 V or more and/or is rated to accommodate currents of at least 1A, and more typically currents of 10A, 50A, 100A or more. Examples of power semiconductor dies include discrete power diodes and discrete power transistor dies, e.g., MOSFETs (Metal Oxide Semiconductor Field Effect Transistors), IGBTs (Insulated Gate Bipolar Transistors), and HEMTs (High Electron Mobility Transistors), etc. Separately or in combination, the semiconductor dies 108 mounted on the circuit carrier 102 may comprise other types of devices, e.g., logic devices, custom circuits, controllers, sensing devices, passive elements, etc.

The semiconductor module 100 may be configured as a power converter or power inverter. For example, the semiconductor dies 108 may be power transistors that form the high-side switch and low-side switch of a half-bridge circuit. The power module may additionally comprise one or more driver dies that control a switching operation of the half-bridge circuit. The power module may additionally include passive devices, e.g., capacitors, inductors, resistors, etc.

The semiconductor module 100 comprises a housing 114 that surrounds an interior volume over the circuit carrier 102. The interior volume refers to a three-dimensional space that the circuit carrier 102 and elements mounted thereon are disposed within. To this end, the housing 114 comprises a baseplate 116 and sidewalls 118 that are affixed to the baseplate 116. The sidewalls 118 may form an enclosed geometry from a plan-view perspective of semiconductor module 100. The semiconductor module 100 may further comprise a cover (not shown) that can be securely affixed to upper ends of the sidewalls 118, thereby forming a complete seal around the interior volume. The sidewalls 118 may be formed from a plastic material, for example. The baseplate 116 may be formed from a thermally conductive material, such as a metal, e.g., copper, aluminum, alloys thereof, etc. As shown, the sidewalls 118 and the second metallization layer 110 of the circuit carrier 102 may each be affixed to the baseplate 116 by layers of adhesive material 120. The layers of adhesive material 120 may be any kind of electronics adhesive, including polymer-based electronics glue.

The semiconductor module 100 comprises terminals 122 that extend away from an upper side of the semiconductor module 100. The terminals 122 are electrically conductive structures that form external points of electrical contact to the nodes of the circuits contained within the interior volume. The terminals 122 may be formed from an electrically conductive material, such as a metal, e.g., copper, aluminum, alloys thereof, etc. As shown, the terminals 122 are anchored within the sidewalls 118 of the housing 114. In other embodiments, the terminals 122 are directly attached to the circuit carrier 102, e.g., by soldering or welding. Separately or in combination, the terminals 122 may have a wide variety of geometric configurations. For example, at least some of the terminals 122 may be configured as press-fit connectors.

The semiconductor module 100 comprises electrical interconnect elements 124 that are used to effectuate an electrical interconnection between the terminals of the elements mounted on the circuit carrier 102. As shown, the electrical interconnect elements 124 are configured as conductive bond wires. These bond wires connect terminals of the semiconductor dies to the structured metallization layer 104 and connect the structured metallization layer 104 to the terminals 122. More generally, the electrical interconnect elements 124 can be any type of interconnect element, e.g., clips, ribbons, bond wires, etc., that are attached to the devices and/or metal pads of the semiconductor module 100 using any known technique. Additionally, the semiconductor module 100 may comprise additional metal structures, such as tabs or busbar structures (not shown) that deliver fixed voltages to the various devices mounted on the on the circuit carrier 102.

The semiconductor module 100 comprises a potting compound 126 that is disposed within the interior volume. The potting compound 126 encapsulates the semiconductor dies, the electrical interconnect elements 124 and the circuit carrier 102. The potting compound 126 protects these elements from exterior environmental conditions and mechanical damage and provides dielectric isolation between elements that operate at a different electrical potential. The potting compound 126 may comprise electrically insulating encapsulant materials that are used in electronics applications to protect semiconductor dies. The potting compound 126 may comprise a polymer matrix of a thermosetting plastic or thermoplastic. According to an embodiment, the encapsulant is a curable dielectric gel, such as a silicone-based dielectric gel.

The semiconductor module 100 comprises a concentration of sacrificial particles 128. The sacrificial particles 128 are particles that are dedicated to corrode in the presence of a corrosive agent. The corrosion of the sacrificial particles 128 deprives the metal surfaces within the semiconductor module 100 that may be harmed by corrosion from the corrosive element of the agent. Stated another way, the sacrificial particles 128 supplant the corrosion from occurring in areas at which it would be harmful.

The concentration of sacrificial particles 128 is dispersed within a volume of electrically insulating polymer that is within the interior volume of the semiconductor module 100. In this context, the term dispersed means that the sacrificial particles 128 are spread out from one another in the in a homogenous or quasi-homogeneous distribution. The volume of electrically insulating polymer that the sacrificial particles 128 are dispersed within can be any of one or more regions within the semiconductor module 100. These different regions can be regions of encapsulant, epoxy, adhesive material 120, or coating material. As shown, the sacrificial particles 128 are dispersed throughout the volume of the electrically insulating potting compound 126. Additionally, the sacrificial particles 128 are dispersed throughout the adhesive layer that 120 is between the second metallization layer 110 of the circuit carrier 102 and the baseplate 116. In this way, the metal surfaces of the semiconductor module 100 that are vulnerable to corrosion including the surfaces on the upper side of the circuit carrier 102 and the surfaces on the surfaces on the lower side of the circuit carrier 102 are protected. Separately or in combination, the volume of electrically insulating polymer that the sacrificial particles 128 are dispersed within can be a coating layer that covers a metal surface of the semiconductor module 100. For instance, the surfaces of the structured metallization layer 104 and/or the electrical interconnect elements 124 may be covered with a coating (not shown) that is different from the potting compound 126, and the sacrificial particles 128 may be dispersed within this coating. This coating can be an epoxy resin or other type of potting material different from the potting compound 126, for example.

According to an embodiment, the sacrificial particles 128 comprise a metal salt, semi-metal salt, metal oxide, or semi-metal oxide with a cation. The cation may be any multivalent cation, e.g., an ion with a net +1 charge, an ion with a net +2 charge (divalent cation), an ion with a net +3 charge (trivalent cation), and so forth. Metal salts are ionic compounds with metallic cations that replace the hydrogen of an acid. Metal oxides are ionic compounds between a metal cation and an oxygen anion. The cation of a metal salt or a metal oxide comes from the elements of the periodic table that are classified as metals. Examples of metal salts or metal oxides with a divalent cation include Zinc Oxide (ZnO), cupric oxide (CuO), cupric oxide (Cu2O), Zinc sulfate (ZnSO₄), cupric sulfate (CuSO₄), tungsten trioxide (WOs), and iron oxide (Fe₃O₄). Semi-metal salts and semi-metal oxide are ionic compounds with semi-metallic cations. Examples of semi-metal salts or semi-metal oxides oxides or salts of Antimony (Sb) wherein the Antimony molecule has an oxidation state of +3 and +5.

The process by which the sacrificial particles 128 protect the elements of the semiconductor module 100 is as follows. Most insulating polymers, such as potting compounds, epoxy resins, etc. are generally very effective at protecting electronic components from damaging environmental conditions such as temperature, humidity, particles, etc. However, certain gasses that may be present in certain settings may be able to penetrate these otherwise effective protective structures. In particular, a sulfur containing gas, such as hydrogen sulfide (H₂S), methanethiol (CH₃SH), or dimethyl sulfide ((CH₃)₂S), etc., may be able to diffuse through one of these protective structures and cause corrosion with the metal surfaces that are encapsulated. For example, metal surfaces such as copper, aluminum, silver, etc., can form corresponding metal sulfides in the presence of a sulfur containing gas, which can form as dendrites. This corrosion can cause problems such as delamination and failure of the components. By dispersing the sacrificial particles 128 in the polymers that surround and/or are in the vicinity of the metal surfaces and/or at locations that are exposed to the exterior environment, the embodiments disclosed herein remove the threat posed by the corrosive gas with a structure that experiences the corrosion and deprives the exposed metal surfaces from the corrosive sulfur.

By using sacrificial particles 128 of a metal salt, semi-metal salt, metal oxide or semi-metal oxide with a cation, certain advantages over other types of sacrificial particles 128 are realized. The size of the sacrificial particles 128 can be smaller than other types of sacrificial particles 128. By way of comparison, particles of an elemental metal, e.g., copper, zinc, can only typically be provided in the range of 1µm or more. This requires a high viscosity of the matrix material to which the particles are dispersed within, e.g., a dynamic viscosity of at least 1000 mPa*s (millipascal seconds), 2000 mPa*s or more, so that these particles can disperse in a relatively uniform manner without sedimentation. Raising the dynamic viscosity may hinder the effectiveness of an encapsulation material as a protective structure. By contrast, the sacrificial particles 128 of a metal salt, semi-metal salt, metal oxide or semi-metal oxide as described herein can be provided in the range of 500 nm or less, e.g., less than 250 nm, less than 100 nm, etc. This in allows for a lower viscosity of the polymer matrix material, e.g., a dynamic viscosity of the potting compound 126 of less than 1000 mPa*s, less than 500 mPa*s, etc. Moreover, this may eliminate the need to provide other filler materials in the polymer matrix to which the sacrificial particles 128 are disposed within. Additionally, the sacrificial particles 128 of a metal salt, semi-metal salt, metal oxide or semi-metal oxide as described herein are electrically non-conductive. Thus, in contrast to elemental metallic particles, e.g., copper, silver, palladium, the sacrificial particles 128 do not lower the dielectric strength of the polymer to which they are dispersed within. Moreover, because the sacrificial particles 128 comprise a divalent cation, they form a sulfide without an oxidation step. Accordingly, sulfide formation with the metal salts or metal oxides with a divalent cation can occur in low oxygen and-or low humidity environments. This differs from other types of particles, such as sacrificial particles of an elemental metal, e.g., copper, zinc, which require an oxygen environment to illicit a reaction with a sulfur containing gas, and this process is enhanced by humidity.

According to an embodiment, the sacrificial particles 128 form a stable sulfide with a sulfur containing gas. In this context, a stable sulfide refers to a sulfide that is not chemically reactive and retains its properties during the useful lifetime and temperature range of the semiconductor module 100, e.g., between -40°C and 250°C. By contrast, an instable sulfide may polymerize, decompose, corrode or dissolve within the polymer matrix during the useful lifetime of the semiconductor module 100. In an exception to this, the sacrificial particles 128 may be able to decompose if the particle is a metal oxide and its oxidative sulfide decomposition leads to the regeneration of a metal oxide and SO₂ such that the sulfur containing gas can be trapped temporarily and the absorber material is restored slowly with O₂ and heat, releasing (harmless) SO₂ gas. Examples of cations that form stable sulfides with a sulfur containing gas include Cu²⁺, Hg²⁺, Bi²⁺, Fe²⁺, Sb²⁺, Sb^{3+,} Sn²⁺, Co²⁺, Ni²⁺, Mn²⁺, Zn²⁺, W⁶⁺.

According to an embodiment, the sulfide formed by the sacrificial particles 128 has a solubility product of less than 10⁻¹⁰ mol²/l². The sulfide formed by the divalent cation refers to the sulfide which forms after the above-described reaction with a sulfur containing gas. For example, Cu₂S is the sulfide formed by sacrificial particles 128 wherein the divalent cation is Cu²⁺, Zn₂S is the sulfide formed by sacrificial particles 128 wherein the divalent cation is Zn²⁺, and so forth. Solubility product is a measurement of the molar concentration of dissolved ions within water at room temperature (25° C). Thus, the sulfide formed by the divalent cation may be considered sparingly soluble. By maintaining a low water solubility, the water uptake of the polymer material to which the sacrificial particles 128 is dispersed within can be maintained low, which is generally preferably to protect the elements encapsulated by the polymer material.

According to an embodiment, the concentration of sacrificial particles 128 relative to the matrix polymer to which they are dispersed within is between 0.1 %-50%. On the higher end of this range, high concentration values such as concentration values exceeding 10% can have beneficial anti-corrosion effects. Moreover, these concentration values exceed that which is possible or at least preferable using metallic particles, because the electrical conductivity of metallic particles lowers the volume resistance and breakthrough voltage of the insulating matrix material and thus lower the electrical performance of the material. As the sacrificial particles 128 disclosed herein are electrically non-conductive, this issue is avoided. Alternatively, the concentration of sacrificial particles 128 relative to the matrix polymer may be between 1%-10%. As the sacrificial particles 128 can be quite effective at these lower levels and in fact may be more effective than metallic particles, this concentration may be preferred in some cases and may allow for lower viscosity of the matrix polymer material.

According to an embodiment, a dynamic viscosity of the electrically insulating polymer material to which the sacrificial particles 128 dispersed within is below 1000 mPa*s. The properties of the of sacrificial particles 128 disclosed herein advantageously allow a lower dynamic viscosity without sedimentation, which in turn allows for easier processing, e.g., potting or encapsulation process.

In the embodiment shown in Figure 1, the sacrificial particles 128 are dispersed throughout an entire volume of the electrically insulating potting compound 126. That is, the sacrificial particles 128 are spread out from one another in a homogenous or quasi-homogeneous distribution throughout the potting compound 126. This arrangement may be obtained by a one-layer and one-step potting process wherein the potting compound 126 is intermixed with the sacrificial particles 128 while the potting compound 126 is in a gelatinous state before the curing process. Such a one-layer and one-step potting process advantageously lowers encapsulation costs. In this case, the adhesive layer 120 between the sidewalls 118 and the baseplate 116 may be devoid of the sacrificial particles 128, as the presence of the potting compound 126 with the sacrificial particles 128 in a lower region of the semiconductor module 100 may provide protection from corrosive gasses entering the interior volume in this region.

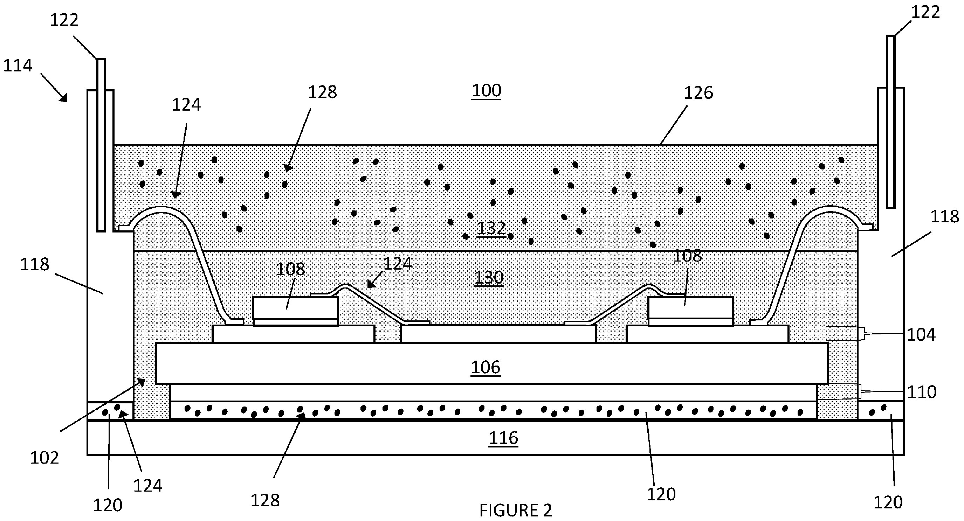

Referring to Figure 2, a semiconductor module 100 is depicted, according to another embodiment. Different to the embodiment of Figure 1, in this embodiment, the semiconductor module 100 comprises two layers of potting compound 126. A first layer 130 of potting compound covers the circuit carrier 102 and encapsulates the semiconductor dies 108. A second layer 132 of potting compound covers is formed on top of the first layer 130 and is spaced apart from the circuit carrier 102. The second layer 132 comprises the sacrificial particles 128 dispersed throughout a volume of the second layer 132. Meanwhile, the first layer 130 is devoid of the sacrificial particles 128. According to this arrangement, the second layer 132 acts as a cover region that gasses must diffuse through before reaching the lower region of the interior volume. The sacrificial particles 128 in the second layer 132 react with and absorb the corrosive element of the corrosive gasses in the above-described manner. In this case, the adhesive 120 layer between the sidewalls 118 and the baseplate 116 may comprise sacrificial particles 128 dispersed therein so as to provide protection from corrosive gasses entering the interior volume in this region. In this example, the first and second layers 130, 132 of potting compound 126 may comprise above-described materials, such as a silicone based potting compound 126. The first and second layers 130, 132 of potting compound 126 may have different properties from one another, e.g., viscosity, composition, filler materials, etc.

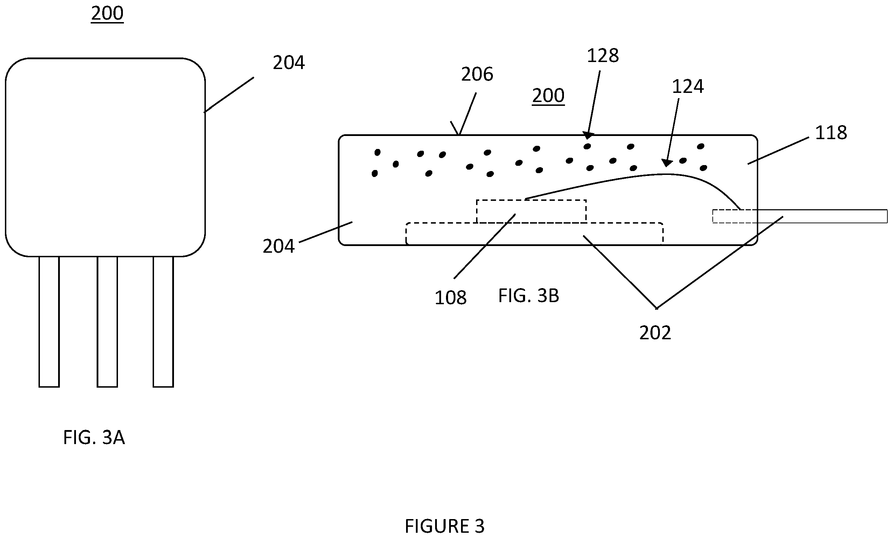

Referring to Figure 3, a semiconductor package 200 is depicted, according to an embodiment. Generally speaking, the semiconductor package 200 can have a wide variety of configurations, e.g., discrete device package, integrated device, etc. The semiconductor package 200 comprises a metal lead frame 202 with a die pad and a plurality of leads extending away from the die pad. A semiconductor die 108 is mounted on the lead frame 202 and is electrically connected to the leads using electrical interconnect elements 124, e.g., bond wires as shown.

The semiconductor package 200 comprises an encapsulant body 204 of encapsulant material 116. The encapsulant body 204 can be formed by a molding process such as injection molding, transfer molding, compression molding, etc. According to these techniques, a lead frame assembly comprising the lead frame 202 with the semiconductor die mounted 108 thereon is arranged into a molding tool, a mold compound is injected into the molding tool and is subsequently cured to form the encapsulant body 204. Generally speaking, the mold compound can comprise dielectric materials such as epoxy, thermosetting plastic, polymer, resin, etc.

The semiconductor package comprises a concentration of the sacrificial particles 128 dispersed within a volume of electrically insulating polymer. For example, as shown, the sacrificial particles 128 may be dispersed within the encapsulant body 204. Separately or in combination, the sacrificial particles 128 may be dispersed within a coating formed on an electrical conductor that is encapsulated by the encapsulant body 204. These metal surfaces include the metal surfaces of the lead frame 202 or the electrical interconnect elements 124.

Although the present disclosure is not so limited, the following numbered examples demonstrate one or more aspects of the disclosure.

Example 1. A semiconductor module, comprising: a power electronics carrier comprising a structured metallization layer disposed on an electrically insulating substrate; a power semiconductor die mounted on the power electronics carrier;
a housing that surrounds an interior volume over the power electronics carrier; a volume of electrically insulating polymer material disposed within the interior volume; and a concentration of sacrificial particles dispersed within the volume of electrically insulating polymer, wherein the sacrificial particles are a metal salt, semi-metal salt, metal oxide, or semi-metal oxide with a cation.

Example 2. The semiconductor module of example 1, wherein the cation forms a stable sulfide with a sulfur containing gas.

Example 3. The semiconductor module of example 2, wherein the cation is any one of: Cu²⁺, Hg²⁺, Bi²⁺, Fe²⁺, Sb²⁺, Sn²⁺, Co²⁺, Ni²⁺, Mn²⁺, Zn²⁺, W⁶⁺.

Example 4. The semiconductor module of example 2, wherein the metal salt, semi-metal salt, metal oxide, or semi-metal oxide is any one of: ZnO, CuO, Cu₂O, ZnSO₄, CuSO₄, WO₃, Fe₃O₄, Fe₂O₃.

Example 5. The semiconductor module of example 2, wherein the stable sulfide has a solubility product of less than 10¹⁰ mol²/l²

Example 6. The semiconductor module of example 1, wherein the concentration of sacrificial particles relative to the electrically insulating polymer is between 0.1%-50%.

Example 7. The semiconductor module of example 6, wherein the concentration of sacrificial particles is between 1%-10%.

Example 8. The semiconductor module of example 1, wherein the volume of electrically insulating polymer is a potting compound that covers the power electronics carrier and encapsulates the semiconductor die.

Example 9. The semiconductor module of example 8, wherein a dynamic viscosity of the potting compound is below 1000 mPa*s.

Example 10. The semiconductor module of example 8, wherein the sacrificial particles are dispersed throughout an entire volume of the electrically insulating potting compound.

Example 11. The semiconductor module of example 8, wherein the potting compound comprises a first layer that covers the power electronics carrier and encapsulates the power semiconductor die and a second layer that is formed on top of the first layer and is spaced apart from the power electronics carrier, wherein the sacrificial particles are dispersed throughout the second layer, and wherein the first layer is devoid of the sacrificial particles.

Example 12. The semiconductor module of example 1, wherein the volume of electrically insulating polymer that the sacrificial particles dispersed within is an adhesive layer.

Example 13. The semiconductor module of example 1, wherein the volume of electrically insulating polymer that the sacrificial particles are dispersed within is a coating layer that covers a metal surface of the semiconductor module.

Example 14. A semiconductor device, comprising: a semiconductor die; an encapsulant body of electrically insulating material that encapsulates the semiconductor die; and a concentration of sacrificial particles dispersed within an electrically insulating region of the semiconductor device, wherein the sacrificial particles comprise a metal salt, semi-metal salt, metal oxide, or semi-metal oxide with a cation.

Example 15. The semiconductor device of example 14, wherein the concentration of sacrificial particles is dispersed within the encapsulant body.

Example 16. The semiconductor device of example 14, wherein the semiconductor device comprises a coating formed on an electrical conductor that is encapsulated by the encapsulant body.

The semiconductor dies 108 disclosed herein can be formed in a wide variety of device technologies that utilize a wide variety of semiconductor materials. Examples of such materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AllnN), indium gallium nitride (InGaN), aluminum gallium indium nitride (AIGalnN) or indium gallium arsenide phosphide (InGaAsP), etc.

The semiconductor dies 108 disclosed herein may be configured as a vertical device, which refers to a device that conducts a load current between opposite facing main and rear surfaces of the die. Alternatively, the semiconductor dies 108 may be configured as a lateral device, which refers to a device that conducts a load current parallel to a main surface of the die.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims and their legal equivalents.

## Claims

1. A semiconductor module, comprising:
a power electronics carrier comprising a structured metallization layer disposed on an electrically insulating substrate;
a power semiconductor die mounted on the power electronics carrier;
a housing that surrounds an interior volume over the power electronics carrier;
a volume of electrically insulating polymer material disposed within the interior volume; and
a concentration of sacrificial particles dispersed within the volume of electrically insulating polymer,
wherein the sacrificial particles are a metal salt, semi-metal salt, metal oxide, or semi-metal oxide with a cation.

2. The semiconductor module of claim 1, wherein the cation forms a stable sulfide with a sulfur containing gas.

3. The semiconductor module of claim 2, wherein the cation is any one of: Cu²⁺, Hg²⁺, Bi²⁺, Fe²⁺, Sb²⁺, Sn²⁺, Co²⁺, Ni²⁺, Mn²⁺, Zn²⁺, W⁶⁺.

4. The semiconductor module of claim 2, wherein the metal salt, semi-metal salt, metal oxide, or semi-metal oxide is any one of: ZnO, CuO, Cu₂O, ZnSO₄, CuSO₄, WOs, Fe₃O₄, Fe₂O₃.

5. The semiconductor module of claim 2, wherein the sulfur containing gas is Hydrogen Sulfide (H₂S).

6. The semiconductor module of claim 2, wherein the stable sulfide has a solubility product of less than 10¹⁰ mol²/l².

7. The semiconductor module of claim 1, wherein the concentration of sacrificial particles relative to the electrically insulating polymer is between 0.1%-50%.

8. The semiconductor module of claim 7, wherein the concentration of sacrificial particles is between 1%-10%.

9. The semiconductor module of claim 1, wherein the volume of electrically insulating polymer is a potting compound that covers the power electronics carrier and encapsulates the semiconductor die.

10. The semiconductor module of claim 9, wherein a dynamic viscosity of the potting compound is below 1000 mPa*s.

11. The semiconductor module of claim 8, wherein the potting compound comprises a first layer that covers the power electronics carrier and encapsulates the power semiconductor die and a second layer that is formed on top of the first layer and is spaced apart from the power electronics carrier, wherein the sacrificial particles are dispersed throughout the second layer, and wherein the first layer is devoid of the sacrificial particles.

12. The semiconductor module of claim 1, wherein the volume of electrically insulating polymer that the sacrificial particles are dispersed within is
an adhesive layer, or
a coating layer that covers a metal surface of the semiconductor module.

13. A semiconductor device, comprising:
a semiconductor die;
an encapsulant body of electrically insulating material that encapsulates the semiconductor die; and
a concentration of sacrificial particles dispersed within an electrically insulating region of the semiconductor device,
wherein the sacrificial particles comprise a metal salt, semi-metal salt, metal oxide, or semi-metal oxide with a cation.

14. The semiconductor device of claim 13, wherein the concentration of sacrificial particles is dispersed within the encapsulant body.

15. The semiconductor device of claim 13, wherein the semiconductor device comprises a coating formed on an electrical conductor that is encapsulated by the encapsulant body.
